# DEMANDE DE BREVET EUROPEEN

(11) **EP 0 702 440 A1**
(43) Date de publication de la demande: **20.03.1996**
(21) Numéro de dépôt: 95402059.0
(22) Date de dépôt: 12.09.1995
(51) Int. Cl.: H01S 3/25, H01S 3/085

(54) **Procédé de réalisation de diodes laser à émission surfacique**

(30) Priorité: 16.09.1994 FR 9411071
(71) Demandeur: THOMSON-CSF, F-75008 Paris (FR)
(72) Inventeur: Maurel, Philippe, F-92402 Courbevoie Cedex (FR); Garcia, Jean-Charles, F-92402 Courbevoie Cedex (FR); Hirtz, Jean-Pierre, F-92402 Courbevoie Cedex (FR)
(74) Mandataire: Guérin, Michel

(57) **Abrégé**

L'invention concerne un procédé de réalisation d'un ensemble de diodes lasers à émission surfacique. Ce procédé comprend la réalisation de réflecteurs par épitaxie d'au moins un matériau semiconducteur au travers d'un masque présentant des ouvertures avec des flancs inclinés. Ce procédé conduit à l'obtention des réflecteurs de Bragg obtenus in situ permettant de s'affranchir de la gravure ionique d'un substrat semiconducteur puis d'une phase de conditionnement de la surface de l'échantillon avant l'élaboration de la structure laser recherchée.

Application: Source optique de puissance.

## Description

Le domaine de l'invention est celui des dispositifs optoélectroniques de puissance, dont la partie active est constituée par un circuit intégré regroupant une pluralité de lasers semiconducteurs.

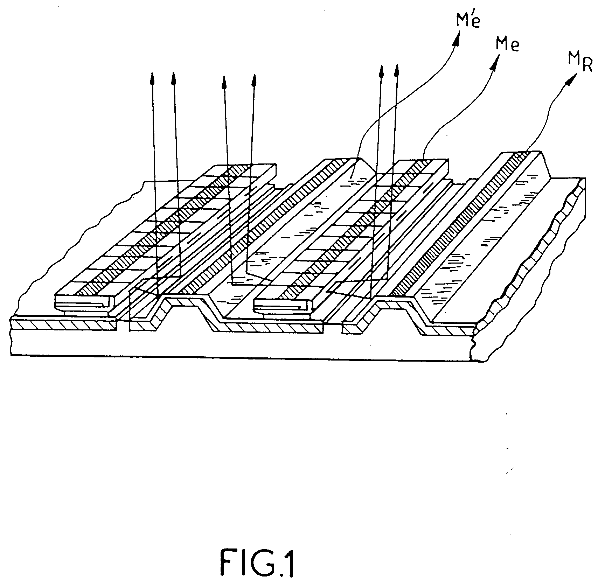

Plus précisément, ce circuit intégré regroupe une pluralité de lasers élémentaires capables d'engendrer des puissances de l'ordre du watt et donc de disposer de sources optiques de puissance proche du kilowatt. Typiquement, ces lasers élémentaires sont associés en barrettes parallèles entre elles, sur la pastille de matériau semiconducteur. Les barrettes sont en relief par rapport à la surface du substrat, de telle sorte qu'elles comportent deux faces élevées, nécessaires au fonctionnement de chaque laser élémentaire, à travers les faces clivées, parallèlement à la surface du substrat. Des jeux de miroirs, disposés entre les barrettes de lasers, réfléchissent à 90° les faisceaux lumineux, et les renvoient perpendiculairement à la surface du substrat. Ces miroirs sont généralement formés par usinage du substrat, en plans inclinés à 45°, puis sont recouverts d'au moins une couche métallique qui sert à la fois de réflecteur optique et de conducteur électrique. Généralement, une première métallisation de prise de contact est déposée sur chaque barrette de lasers (Mₑ), et une deuxième métallisation de prise de contact (M_{R}) est déposée sur chaque réflecteur. L'ensemble des flancs des réflecteurs est également recouvert d'une métallisation (M'_{R}) pour assurer un bon pouvoir réflecteur auxdits éléments réflecteurs. La figure 1 illustre une vue dans l'espace d'un exemple de circuit intégré de lasers à émission surfacique. Les flancs des réflecteurs à 45°, métallisés, conduisent à l'émission surfacique recherchée.

Selon l'art antérieur, les réflecteurs sont généralement obtenus par gravure par usinage ionique d'un substrat en matériaux semiconducteurs du groupe III-V. Puis dans un second temps, on opère des dépôts par épitaxie des couches successives à l'élaboration de la structure laser.

Ce type de procédé inclut alors une phase, toujours délicate, de conditionnement de la surface de l'échantillon, afin de préparer la reprise d'épitaxie de la structure laser sur le substrat gravé.

Afin d'éviter cette étape d'usinage ionique, puis la reprise d'épitaxie de la structure laser sur les réflecteurs à 45° préalablement constitués, l'invention propose un procédé de réalisation permettant d'élaborer des réflecteurs de Bragg faisant un angle θ avec le substrat (cet angle pouvant typiquement être voisin de 45°) par épitaxies sélectives à l'aide d'un masque mécanique. La réalisation de tels réflecteurs permet alors de s'affranchir de l'étape ultérieure de métallisation des réflecteurs de l'art antérieur, étape toujours délicate si l'on ne veut pas altérer les faces actives des structures lasers, lesdites faces étant très proches des flancs réflecteurs.

Plus précisément, l'invention a pour objet un procédé de réalisation d'un dispositif optoélectronique de puissance, émetteur de lumière cohérente fournie par une pluralité de lasers élémentaires à émission surfacique, caractérisé en ce qu'il comporte les étapes suivantes :
* la réalisation à travers un masque mécanique possédant des ouvertures présentant des flancs inclinés de réflecteurs par épitaxie d'au moins un matériau semiconducteur, lesdits réflecteurs présentant des flancs faisant un angle θ avec le plan du substrat sur lequel ils sont élaborés;
* la croissance par épitaxies sélectives de couches constitutives de la structure laser sur lesdits réflecteurs.

L'angle θ recherché peut être ajusté grâce à la distance du masque mécanique par rapport au plan du substrat.

Dans le procédé selon l'invention, on peut ainsi réaliser dans un premier temps, la croissance de réflecteurs en un matériau semiconducteur (I), au travers du masque mécanique, puis dans un second temps, après enlèvement du masque in situ, réaliser par épitaxies sélectives de matériaux semiconducteurs (A) et (B), la croissance de miroirs de Bragg.

Selon une autre alternative, on peut également réaliser directement au travers du masque mécanique, la croissance de miroirs de Bragg par épitaxies sélectives de matériau semiconducteurs (A) et (B), sur le substrat plan.

On peut alors dans un second temps, procéder à l'élimination de la structure laser, au niveau des miroirs de Bragg pour ne laisser ladite structure laser que sur des éléments de substrat insérés entre deux miroirs de Bragg.

L'invention sera mieux comprise et d'autres avantages apparaîtront à la lecture de la description qui va suivre, donnée à titre non limitatif et des figures annexées parmi lesquelles:
- la figure 1 illustre une vue globale d'un dispositif optoélectronique de puissance, émetteur de lumière cohérente fournie par une pluralité de lasers élémentaires à émission surfacique;
- la figure 2 illustre une étape du procédé de réalisation de dispositifs analogues à celui du dispositif illustré à la figure 1, utilisant un masque mécanique pour élaborer les miroirs de Bragg;
- la figure 3 illustre un autre exemple de procédé selon l'invention, dans lequel les miroirs de Bragg sont réalisés sur un substrat élaboré par épitaxie au travers d'un masque mécanique;
   * la figure 3a schématise la réalisation des réflecteurs au travers du masque mécanique
   * la figure 3b schématise la réalisation des miroirs de Bragg sur les réflecteurs préalablement formés
- la figure 4 illustre une étape de gravure ionique en fin de procédé, pouvant être utilisée pour réaliser des puits nécessaires à l'élaboration des structures lasers;
- la figure 5 illustre une étape de sous gravure succédant à l'étape illustrée en figure 4:
   * la figure 5a schématise une étape d'attaque chimique de sous-gravure
   * la figure 5b schématise une étape d'usinage des "poutres" obtenues à l'issue de l'étape précédente
- la figure 6 illustre un ensemble de diodes lasers obtenues selon le procédé de l'invention.

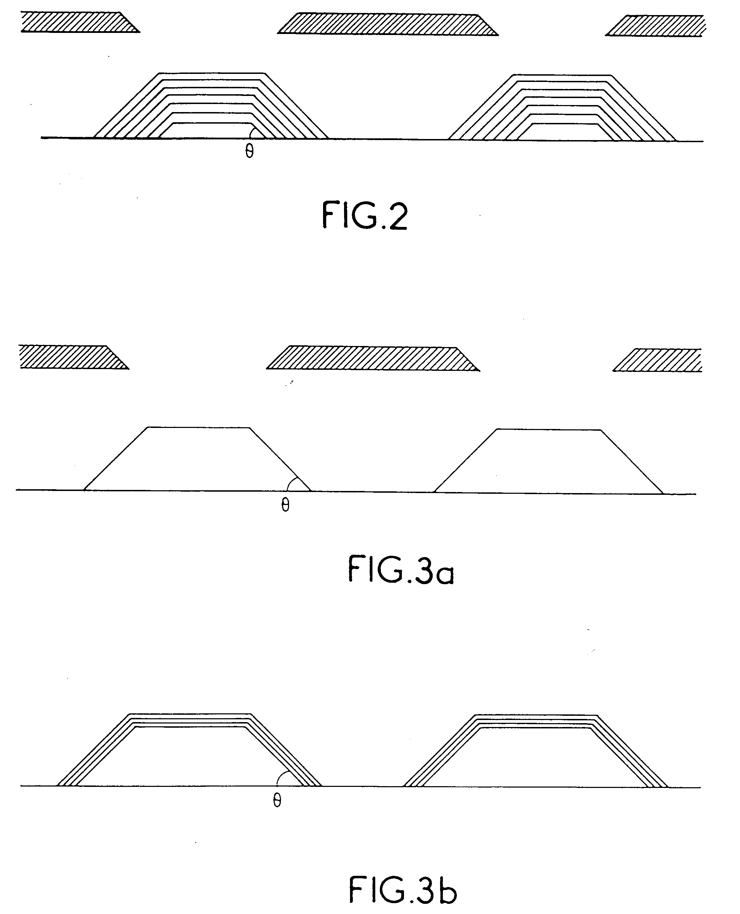

Le procédé de réalisation, selon l'invention, de dispositif optoélectronique comprenant des éléments lasers à émission surfacique, utilise de préférence un substrat en matériaux de la famille III-V, il peut typiquement s'agir de GaAs ou d'lnP. A partir d'un tel substrat et d'un masque mécanique de géométrie contrôlée avec des ouvertures présentant des flancs optiques schématisés à la figure 2, on peut réaliser en ajustant le rapport ouverture sur éloignement du masque, des structures de forme trapézoïdale présentant des flancs pouvant être typiquement à environ 45° du substrat. On peut ainsi par dépôts alternés de matériaux semiconducteurs tels que GaAlAs et GaAs réaliser des couches d'épaisseur égale au quart de la longueur d'onde du laser semiconducteur ultérieurement réalisé. Typiquement, dans le cas de lasers émettant à 0,8 µm, les couches constitutives des réflecteurs de Bragg ont une épaisseur d'environ 0,2 µm. Les éléments réflecteurs ainsi élaborés peuvent avantageusement avoir une hauteur voisine de 20 µm.

Il est également possible de réaliser les réflecteurs, avec miroirs de Bragg en deux temps. C'est-à-dire dans un premier temps élaborer au travers d'un masque mécanique tel que celui décrit précédemment, un réflecteur en matériau type GaAs, retirer in situ le masque mécanique pour réaliser par épitaxies sélectives l'alternance de couches de GaAs/GaAlAs permettant d'obtenir les miroirs de Bragg désirés (figures 3a et 3b).

La dernière couche constitutive des miroirs de Bragg peut typiquement être en GaAlAs et ainsi jouer aussi le rôle de couche dite d'arrêt à l'étape de sous gravure décrite ultérieurement.

Dans les deux cas de figures, on dispose d'un ensemble de réflecteurs présentant des flancs faisant un angle θ avec le substrat.

On peut alors réaliser in situ la croissance de la structure laser sur le substrat comprenant les réflecteurs de Bragg.

Dans un premier temps, on peut déposer une couche (Cₗ) épaisse (environ 6 µm) de GaAs susceptible d'être attaquée par une solution qui n'attaque pas GaAlAs.

On réalise alors une succession : de couches (C_{II}) en GaAlAs de confinement optique, un ensemble de couches (C_{III})ᵢ nécessaires à la structure laser proprement dite, selon l'art connu, une seconde couche de confinement (C_{IV}) en GaAlAs.

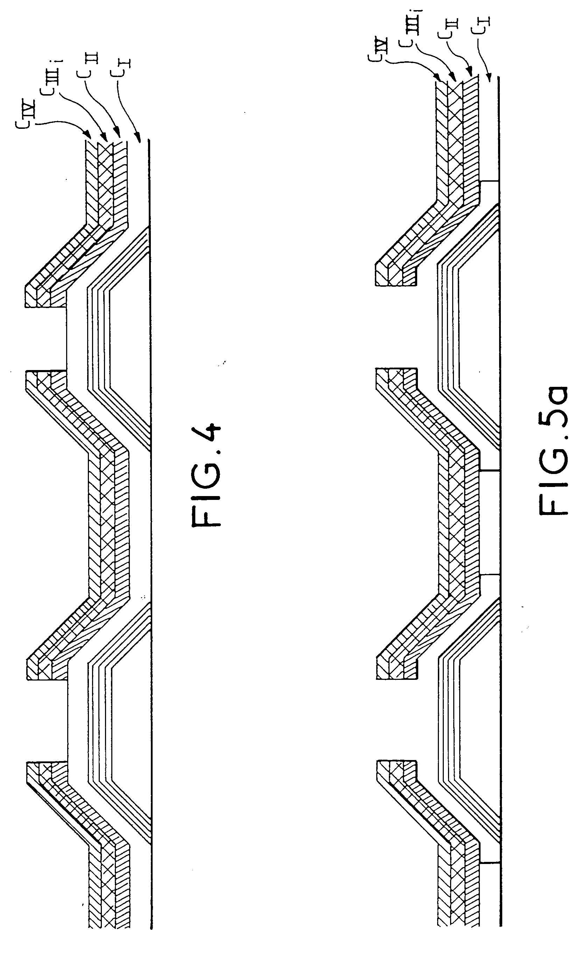

Par gravure ionique, on réalise localement des puits jusqu'à la couche (C_{I}) comme l'illustre la figure 4.

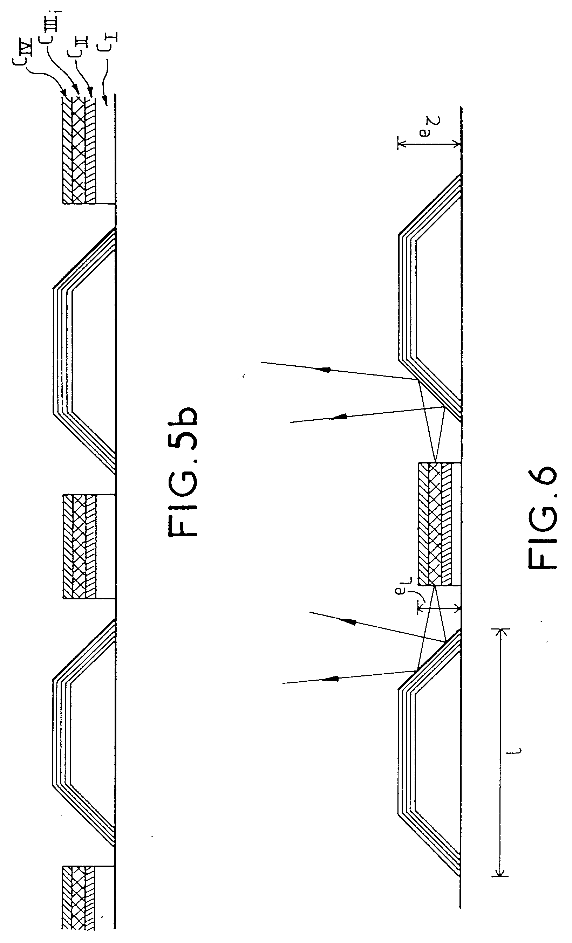

Ainsi par attaque chimique avec une solution sélective, de type (acide citrique, H₂O₂, H₂O) on réalise la sous gravure permettant d'élaborer des "poutres" telles que celles illustrées en figure 5a. Dans un dernier temps, on élimine par usinage ionique, les parties qui sont en porte à faux (figure 5b).

On obtient ainsi un ensemble de diodes lasers à émission surfacique, dont l'épaisseur e_{L} représentées à la figure 6 est de préférence inférieure à celles des réflecteurs d'épaisseurs eᵣ, de manière à récupérer au mieux l'émission divergente desdites diodes, typiquement e_{L} peut être de l'ordre de 12 µm si eᵣ est de l'ordre de 20 µm. Dans ces exemples, la largeur I des réflecteurs peut typiquement être voisine de 40 à 50 µm.

## Revendications

1. Procédé de réalisation d'un dispositif optoélectronique de puissance, émetteur de lumière cohérente fournie par une pluralité de lasers élémentaires à émission surfacique, caractérisé en ce qu'il comporte les étapes suivantes:
* la réalisation à travers un masque mécanique possédant des ouvertures présentant des flancs inclinés de réflecteurs par épitaxie d'au moins un matériau semiconducteur, lesdits réflecteurs présentant des flancs faisant un angle θ avec le plan du substrat sur lequel ils sont élaborés;
* la croissance par épitaxies sélectives de couches constitutives de la structure laser sur lesdits réflecteurs.

2. Procédé de réalisation d'un dispositif optoélectronique selon la revendication 1, caractérisé en ce que:
* on réalise dans un premier temps, la croissance de réflecteurs en un matériau semiconducteur (I), au travers du masque mécanique;
* dans un second temps, après enlèvement du masque in situ, on réalise par épitaxies sélectives de matériaux semiconducteurs (A) et (B), la croissance de miroirs de Bragg.

3. Procédé de réalisation d'un dispositif optoélectronique selon la revendication 1, caractérisé en ce que l'on réalise au travers du masque mécanique, la croissance de miroirs de Bragg par épitaxies sélectives de matériaux semiconducteurs (A) et (B), sur un substrat plan.

4. Procédé de réalisation d'un dispositif optoélectronique selon l'une des revendications 1 à 3, caractérisé en ce que le substrat est en GaAs.

5. Procédé de réalisation d'un dispositif optoélectronique selon l'une des revendications 2 à 4, caractérisé en ce que le matériau (A) est du GaAs et le matériau (B) est du GaAlAs.

6. Procédé de réalisation d'un dispositif optoélectronique selon la revendication 2, caractérisé en ce que le matériau (I) est du GaAs.
